# NEUE EUROPÄISCHE PATENTSCHRIFT

(11) **EP 0 495 755 B2**
(45) Veröffentlichungstag und Bekanntmachung des Hinweises auf die Entscheidung über den Einspruch: **19.12.2001**
(45) Hinweis auf die Patenterteilung: 01.10.1997
(21) Anmeldenummer: 92810010.6
(22) Anmeldetag: 07.01.1992
(51) Int. Cl.: C23C 14/02, C23C 16/02, C22F 1/04, G02B 5/08

(54) **Walzprodukte aus Aluminium**
Aluminium rolled products
Produits de laminage en aluminium

(30) Priorität: 11.01.1991 CH 6891
(43) Veröffentlichungstag der Anmeldung: 22.07.1992
(73) Patentinhaber: Alcan Technology & Management AG, 8212 Neuhausen am Rheinfall (CH)
(72) Erfinder: Textor, Marcus, CH-8200 Schaffhausen (CH); Fuchs, Roman, CH-8212 Neuhausen (CH); Gillich, Volkmar, W-7893 Jestetten (DE); Simon, Erich, W-7700 Singen (DE)

(56) Entgegenhaltungen:
- DE-A- 1 446 273
- FR-A- 1 546 401
- JP-A- 58 132 271
- JP-A- 61 015 330
- JP-A- 82 163 558
- US-A- 4 690 861
- US-A- 4 826 737
- Aluminium-Taschenbuch, 14.Auflage, 1983, Seiten 209-211
- Journal de physique et le radium - Tome 11 - Juillet 1950, p. 394-402 "On the structure and properties of some metal and oxide films" (G.Hass)
- Journal of vacuum Science Technology, vol. 14, no.1 Janv-Feb.1977, p. 123-126 "High rate sputtering of enhanced aluminium mirrors"
- Coatings on glass (Elsevier 1984), p. 358-363, p. 408-413
- Aluminium Taschenbuch 1983, p. 706-707, p. 716, p. 984
- Compte rendu du Congrès "Metallography of advanced materials - 20th Annual technical meeting of the Internat. Metallographic Soc." publié par ASM Internat.- Metals Park Ohio 44073, USA - 1988, dans le recueil "Microstructural Science Vol. 16" p. 447-467: "Characterisation of rolled aluminium"
- Zeitschrift für anorganische Chemie - B. 254 - 1947, p. 96-106: "Über die Struktur dünner Oxydschichten auf Aluminium" G. Hass.

## Beschreibung

Vorliegende Erfindung betrifft Walzprodukte aus Aluminium oder einer Aluminiumlegierung.

Es ist bekannt, Bänder in Glänzwerkstoffen, z.B. Reinstaluminium oder AlMg-Legierungen auf Basis von Aluminium mit einem Reinheitsgrad von 99,8 und grösser, wie z.B. 99,9 % und Walzoberflächen, die diffuse oder gerichtete Lichtreflexion erzeugen, je nach Anwendung, herzustellen. Es ist auch bekannt, zur Erhöhung der Totalreflexion bzw. gerichteten Reflexion die Oberflächen von solchen Bändern chemisch oder elektrolytisch zu glänzen und anschliessend durch anodische Oxidation eine Schutzschicht von z.B. 1-5 µm Schichtdicke zu erzeugen.

Diese bekannten Vorfahren haben den Nachteil, dass teure Glänzlegierungen auf Basis von Reinstaluminium eingesetzt werden müssen. Durch die anodische Oxidschicht sinkt der Reflexionsgrad der Oberfläche, und dabei sowohl die Totalreflexion, wie auch die gerichtete Reflexion, durch Absorption und Lichtstreuung, insbesondere in der Oxidschicht. Dies bedeutet einen Energieverlust.

Chemische Behandlung und dabei insbesondere die Erzeugung der Glänzstufe, ist vom Aspekt der Umweltbelastung durch Abwässer und Abfälle nicht unproblematisch.

Schliesslich weist die anodische Oxidschicht im üblichen Dickenbereich von 1 bis 3 µm oft störende Interferenzeffekte, die sogenannte Irisierung, auf.

Aufgabe vorliegender Erfindung ist es, genannte Nachteile zu vermeiden und Walzprodukte aus Aluminium vorzuschlagen, die wenigstens eine Oberfläche oder Teile wenigstens einer Oberfläche enthalten, die geeignet sind für die Abscheidung von Schichten oder Schichtsystemen aus der Gasphase auf diesen Oberflächen und diese Schichten oder Schichtsysteme die möglichst verlustfreie Reflexion von Energie ermöglichen.

Erfindungsgemass wird das durch die Walzprodukte gemäss Anspruch 1 erreicht Aluminiumlegierungen enthaltend Si werden insbesondere für Oberflächen bevorzugt, die an Gegenständen sind, die durch extrudieren oder pressen hergestellt werden.

Als Gegenstände aus Aluminium können alle räumlichen Gebilde, die wenigstens eine freie Oberfläche aufweisen, zur Anwendung gelangen. Diese freie Oberfläche ist beispielsweise ein Aluminium mit einer Reinheit von 98,3 % und höher, zweckmässig 99,0 % und höher, bevorzugt 99,9 % und höher und insbesondere 99,95 % und höher. Neben Aluminium genannter Reinheiten kann die Oberfläche auch eine Legierung darstellen, bevorzugt beispielsweise Aluminiumlegierungen, enthaltend 0,25 bis 5 Gew.-%, insbesondere 0,5 bis 2 Gew.-%, Magnesium oder enthaltend 0,2 bis 2 Gew.-% Mangan oder enthaltend 0,5 bis 5 Gew.-% Magnesium und 0,2 bis 2 Gew.-% Mangan, insbesondere z.B. 1 Gew.-% Magnesium und 0,5 Gew.-% Mangan oder enthaltend 0,1 bis 12 Gew.-%, vorzugsweise 0,1 bis 5 Gew.-%, Kupfer oder enthaltend 0,5 bis 5 Gew.-% Zink und 0,5 bis 5 Gew.-% Magnesium oder enthaltend 0,5 bis 5 Gew.-% Zink, 0,5 bis 5 Gew-% Magnesium und 0,5 bis 5 Gew.-% Kupfer oder enthaltend 0,5 bis 5 Gew.-% Eisen und 0,2 bis 2 Gew.-% Mangan, insbesondere z.B. 1,5 Gew.-% Eisen und 0,4 Gew.-% Mangan.

Beispiele besonders bevorzugter Oberflächen sind Aluminium mit einer Reinheit von 99,5 % und höher, 99,8 % und höher, 99,85 % und höher, 99,9 % und höher und 99,95 % und höher oder Oberflächen aus einer Aluminiumlegierung enthaltend 0,5 Gew.-% Magnesium oder enthaltend 1 Gew.-% Magnesium oder enthaltend Aluminium einer Reinheit von 99 % und 5 bis 10 und insbesondere 7 Gew.-% Magnesium und 6 bis 12 und insbesondere 8 Gew.-% Kupfer.

Beispiele von Walzprodukten sind Folien, Bänder, Platten, Bleche; gegebenenfalls durch Biegen, Tiefziehen, Kaltfliesspressen und dergleichen umgeformte Teile, ferner Profile, Balken oder andere Formen von Stükken. Je nach Einsatzzweck kann der ganze Gegenstand aus dem genannten Aluminium oder Aluminiumlegierung sein, es können aber auch nur Teilbereiche oder Oberflächenbereiche daraus bestehen.

Bevorzugt sind Gegenstände, die durch Walzen hergestellt werden, d.h. beispielsweise Folien, Bänder oder Bleche enthaltend die unanodisierten Oberflächen. Das genannte Aluminium oder die Aluminiumlegierung kann auch Teil und wenigstens eine Oberfläche oder nur Teiloberfläche eines Verbundes darstellen, z. B. eines Folienverbundes oder Laminates.

An den Walzprodukten sind Walzoberflächen bevorzugt, die mit glatten oder strukturierten Walzen erzeugt werden können. Die Oberflächen können, beispielsweise zwischen einzelnen, mehreren oder allen Walzvorgängen (Stichen) gebeizt werden, dies insbesondere, um den Walzabrieb zu entfernen. Die Beizangriffe auf die Oberflächen können auf an sich bekannte Weise, z.B. sauer oder alkalisch, erfolgen.

Werden zum Walzen strukturierte Walzoberflächen vorgesehen, so kann die Walzoberfläche beispielsweise auf chemischem, physikalischem oder mechanischem Wege strukturiert worden sein, beispielsweise durch Elektronenstrahlerosion, durch Laserstrahlerosion, durch elektrolytische E rosion oder durch Sandstrahlen. Diese Verfahren sind an sich bekannt.

Die unanodisierten Oberflächen können auch einem elektrolytischen oder elektrochemischen Glänzverfahren unterzogen werden. Solche Glänzverfahren sind an sich bekannt und wurden bis anhin vor dem bisher üblichen Anodisieren angewendet.

Zweckmässig weisen die erfindungsgemässen Walzprodukte eine Oberflächenrauhigkeit Ra von 0,1 bis 1 µm und vorzugsweise von 0,3 bis 0,4 µm auf. Diese Oberflächenrauhigkeiten führen zu Gegenständen mit insbesondere matten Oberflächen und vorzugsweise diffuser oder gerichtet streuender Reflexion.

In anderer zweckmässiger Ausführungsform weisen die Walzprodukte eine Oberflächenrauchigkeit Ra gleich oder kleiner als 0,1 µm und vorzugsweise gleich oder kleiner als 0,03 µm auf. Bevorzug ist eine Oberflächenrauhigkeit Ra von 0,001 µm bis 0,03 µm und insbesondere von 0,003 µm bis 0,03 µm. Derartige Oberflächenrauhigkeiten sind insbesondere für die Ausbildung von Gegenständen mit hochglänzenden Oberflächen und gerichteter Reflexion geeignet.

Die Oberflächenrauhigkeit Ra ist definiert in wenigstens einer der DIN-Vorschriften 4761 bis 4768.

Auf den Oberflächen kann ein Schichtsystem für die Reflexion von Energie in Form von Wellen und/oder Teilchen, mit Wellenlängen des sichtbaren Lichtes, insbesondere mit Wellenlängen zwischen 400 bis 750 nm, angebracht werden.

Als Schicht auf der Oberfläche kann beispielsweise eine Lichtreflexionsschicht vorgesehen werden, wie z. B. eine Schicht aus Al, Ag, oder Legierungen, beispielsweise enthaltend wenigstens eines der genannten Elemente.

Beispiele von Schichtsystemen sind solche, die von der erfingungsgemässen Oberfläche ausgehend, aufgebaut sind aus:
- Fallweise einer Haftschicht (Schicht A), wie z.B. eine Keramikschicht. Solche Schichten können beispielsweise Verbindungen der Formeln SiOₓ, wobei x eine Zahl von 1 bis 2 ist, oder AlyOz, wobei y/z eine Zahl von 0,2 bis 1,5 darstellt, enthalten oder daraus bestehen. Bevorzugt ist eine Haftschicht enthaltend SiOₓ, wobei x obige Bedeutung hat.
- Eine Lichtreflexionsschicht (Schicht B), z.B. eine metalliche Schicht enthaltend oder bestehend aus z.B. Al, Ag, Au, Cu, oder Legierungen enthaltend wenigstens eines der genannten Elemente.
- Eine transparente Schutzschicht (Schicht C), z.B. bestehend aus oder enthaltend Oxide, Nitride, Fluoride, usw. von Alkali-, z.B. Li, Na, K, Erdalkali-, z.B. Mg, Ca, Sr, Ba, und/oder Übergangsmetallen, wie z.B. Sc, Ti, V, Cr, Mn, Fe, Co, Ni, Y, Zr, Nb, Mo, Te, Ru, Rh, Pd, Hf, Ta, W, Re, Os, Ir, Pt und/oder Lanthanoiden wie z.B. La, Ce, Pr, Nd, Pm, Dy, Yb oder Lu, usw. Beispiele sind Schichten enthaltend oder bestehend aus PrTi-Oxid und MgF₂ usw. Ferner können zwei oder mehrere transpansparente Schichten (Schichten C, D,...) mit unterschiedlichen Brechungsindices zur Erhöhung des Reflexionsgrades als Folge partieller Lichtreflexion an der Phasengrenze der Schicht C und Schicht D, resp. weiterer Schichten, vorgesehen werden.

Die einzelnen Schichten sind typischerweise 1 bis 200 nm, vorzugsweise 1 bis 100 nm, dick.

Bevorzugt ist ein Schichtsystem enthaltend eine Schicht B und wenigstens eine Schicht C.

Die Schichten können beispielsweise durch Gasoder Dampfphasenabscheidung im Vakuum (physical vapour deposition), durch thermische Verdampfung, durch Elektronenstrahlverdampfung, mit und ohne lonenunterstützung, durch Sputtern, insbesondere durch Magnetronsputtering, oder durch chemische Gasphasenabscheidung (chemical vapour deposition), mit und ohne Plasmaunterstützung, auf der erfindungsgemässen Oberfläche oder der bereits aufgebrachten, vorherigen Schicht abgeschieden werden.

Das Schichtsystem auf der erfingungsgemässen Oberfläche führt zu Gegenständen, die eine Reflexion, gemessen als Reflexionswert nach DIN 67530 Dr. Lange RL 3, von 90 und höher aufweisen.

Das Schichtsystem kann in einer Prozessfolge auf die Oberfläche gebracht werden, welche die Schritte der Entfettung und Reinigung der Oberfläche, das Einschleusen des die Oberfläche enthaltenden Gegenstandes in eine Vakuumanlage, das Reinigen beispielsweise durch Sputtern, durch Entladung (glow discharge) etc., gegebenenfalls in erster Stufe die Abscheidung der Haftschicht (Schicht A), in zweiter Stufe die Abscheidung wenigstens einer lichtfreflektierenden Schicht, z.B. metallischen Schicht (Schicht B), in dritter und gegebenenfalls vierter Stufe und in weiteren Stufen die Abscheidung wenigstens einer transparenten Schicht (Schicht C, gegebenenfalls Schicht D und weitere) und des Ausschleusens des beschichteten Gegenstandes aus dem Vakuum enthält.

Die erfindungsgemässen Walzprodukte, die ein solches Schichtsystem tragen, weisen eine hervorragende Reflexion für im Bereich des sichtbaren Lichtes.

Die Reflexion der Strahlung kann je nach Oberfläche, wie vorbeschrieben, gerichtet, diffus oder eine Kombination davon sein. Demzufolge eignen sich die erfindungsgemässen Walzprodukte aus Aluminium nach der Erfindung, ein Schichtsystem, wie beschrieben, aufweisen, beispielsweise als Reflektoren, wie Reflektoren z.B. für Strahlungsquellen oder optische Geräte. Solche Strahlungsquellen sind z. B. Beleuchtungskörper oder Wärmestrahler. Die Reflektoren sind z.B. Spiegel oder Innenspiegel von optischen Geräten, Beleuchtungskörpern oder Wärmestrahlern.

Beispielsweise verbessern die Walzprodukte nach vorliegender Erfindung die Reflexion um 5 bis 30 %, was ein erhebliches Potential zur Energieeinsparung bzw. Verbesserung der Lichtausbeute darstellen. Es wird auch eine vollständige Freiheit der Irisierung (Interferenzeffekte im sichtbaren Wellenbereich) erreicht.

Die Walzprodukte lassen sich umformen, wobei eine weniger stark sichtbare Rissbildung eintritt, als dies beim derzeitigen Stand der Technik mit anodisierten Oberflächen der Fall ist.

Die Walzprodukte und dabei insbesondere die Oberflächen mit dem Schichtsystem weisen eine gute Schutzwirkung gegen chemischen, physikalischen oder mechanischen Abbau (z.B. Korrosion) auf. Besonders wirksam dafür ist die Schicht C oder Schichten C und D und gegebenenfalls weitere entsprechende Schichten.

Die Walzprodukte aus Aluminium, nach vorliegender Erfindung können zurReflexion von Strahlungen im optischen Bereich, wie z.B. Wärmestrahlung, sichtbares Licht, Ultraviolett, Röntgenstrahlung oder γ-Strahlung etc. verwendet werden. Besondere Bedeutung hat die Reflexion von sichtbarem Licht.

## Patentansprüche

1. Beschichtetes Walzprodukt aus Aluminium oder einer Aluminiumlegierung, **dadurch gekennzeichnet, dass** das Walzprodukt eine unanodisierte Oberfläche aus einem Reinaluminium mit einem Reinheitsgrad von gleich oder grösser 98,3 Gew.-% oder Aluminiumlegierungen aus diesem Aluminium mit wenigstens einem der Elemente aus der Reihe vom Si, Mg, Mn, Cu, Zn, oder Fe aufweisen und die Oberflächen eine Oberflächenrauhigkeit Ra von gleich oder kleiner als 1 µm aufweisen und auf der unanodisierten Oberfläche ein Schichtsystem für die diffuse oder gerichtete Reflexion von Strahlung mit Wellenlängen im sichtbaren Bereich aufgebracht ist, wobei die eine Schicht im Schichtsystem eine Reflexionsschicht aus Al, Ag oder Legierungen, enthaltend wenigstens eines der genannten Elemente, ist und die Reflexionsschicht 1 bis 200 nm dick ist und auf die Reflexionsschicht als weitere Schichten des Schichtsystems zwei oder mehrere transparente Schichten mit unterschiedlichen Brechungsindices zur Erhöhung des Reflexionsgrades angeordnet sind und die einzelnen transparenten Schichten eine Schichtdicke von 1 bis 200 nm aufweisen und die Reflexion, gemessen als Reflexionswert nach DIN 67530 Dr. Lange RL 3, einen Wert von 90 und höher hat.

2. Beschichtetes Walzprodukt nach Anspruch 1, **dadurch gekennzeichnet, dass** die Oberflächenrauhigkeit Ra des Walzproduktes 0,1 bis 1 µm und vorzugsweise 0,3 bis 0,4 µ m beträgt.

3. Beschichtetes Walzprodukt nach Anspruch 1, **dadurch gekennzeichnet, dass** die Oberflächenrauhigkeit Ra des Walzproduktes gleich oder kleiner als 0,1 µm und vorzugsweise gleich oder kleiner als 0,03 µm ist.

4. Beschichtetes Walzprodukt nach Anspruch 1, **dadurch gekennzeichnet, dass** die Oberflächenrauhigkeit Ra des Walzproduktes 0,001 µm bis 0,03 µm und vorzugsweise 0,003 bis 0,03 µm ist.

5. Beschichtetes Walzprodukt nach Anspruch 1, **dadurch gekennzeichnet, dass** auf den unanodisierten Oberflächen der Walzprodukte ein Schichtsystem für die diffuse oder gerichtete Reflexion von Strahlung mit Wellenlängen im Bereich des sichtbaren Lichtes, insbesondere mit Wellenlängen zwischen 400 bis 750 nm, aufgebracht ist.

6. Beschichtetes Walzprodukt nach Anspruch 5, **dadurch gekennzeichnet, dass** die Reflexion gerichtet, diffus oder eine Kombination davon ist.

## Claims

1. Coated rolled product of aluminium or an aluminium alloy, **characterised in that** the rolled product have a non-anodised surface of a pure aluminium having a degree of purity equal to or greater than 98.3 wt.%, or aluminium alloys of this aluminium having at least one of the elements from the series Si, Mg, Mn, Cu, Zn, or Fe, and the surfaces have a surface roughness Ra equal to or less than 1 µm, and a layer system for the diffuse or directed reflection of radiation having wavelengths in the visible range is applied to the non-anodised surface, wherein one layer in the layer system is a reflective layer of Al, Ag or alloys containing at least one of the said elements, and the reflective layer is 1 to 200 nm thick, and two or more transparent layers having different refractive indices are arranged on the reflective layer as further layers of the layer system to increase the degree of reflection and the individual transparent layers have a layer thickness of 1 to 200 nm and the reflection, measured as a reflection value according to DIN 67 530 Dr. Lange RL 3, has a value of 90 and higher.

2. Coated rolled product according to claim 1, **characterised in that** the surface roughness Ra of the rolled product is 0.1 to 1 µm, and preferably 0.3 to 0.4 µm.

3. Coated rolled product according to claim 1, **characterised in that** the surface roughness Ra of the rolled product is equal to or less than 0.1 µm, and preferably equal to or less than 0.03 µm.

4. Coated rolled product according to claim 1, **characterised in that** the surface roughness Ra of the rolled product is 0.001 µm to 0.03 µm, and preferably 0.003 to 0.03 µm.

5. Coated rolled product according to claim 1, **characterised in that** a layer system for the diffuse or directed reflection of radiation having wavelengths in the range of visible light, in particular having wavelengths between 400 to 750 nm, is applied to the non-anodised surfaces of the rolled products.

6. Coated rolled product according to claim 5, **characterised in that** the reflection is directed, diffuse or a combination thereof.

## Revendications

1. Produit laminé revêtu en aluminium ou en un alliage d'aluminium **caractérisé en ce que** le produit laminé présente une surface non anodisée en un aluminium pur ayant un degré de pureté supérieur ou égal à 98,3 % en masse ou en alliages d'aluminium constitués par cet aluminium et au moins l'un des éléments de la série de Si, Mg, Mn, Cu, Zn ou Fe et les surfaces présentent une rugosité de la surface Ra inférieure ou égale à 1 µm, et, sur les surfaces non anodisées est appliqué un système de couches pour la réflexion diffuse ou dirigée d'un rayonnement ayant des longueurs d'onde dans le domaine visible, une couche dans le système de couches étant une couche de réflexion en Al, Ag ou en alliages contenant au moins l'un des éléments cités, et la couche de réflexion étant épaisse de 1 à 200 nm et sur la couche de réflexion sont disposées comme autres couches du système de couches deux ou plusieurs couches transparentes ayant des indices de réfraction différents pour augmenter le degré de réflexion et les différentes couches transparentes ont une épaisseur de couche de 1 à 200 nm et la réflexion, mesurée sous forme de valeur de réflexion selon DIN 67530 Dr. Lange RL 3, a une valeur de 90 et plus.

2. Produit laminé revêtu selon la revendication 1, **caractérisé en ce que** la rugosité de la surface Ra du produit laminé est de 0,1 à 1 µm et de préférence de 0,3 à 0,4 µm.

3. Produit laminé revêtu selon la revendication 1, **caractérisé en ce que** la rugosité de la surface Ra du produit laminé est inférieure ou égale à 0,1 µm et de préférence inférieure ou égale à 0,03 µm.

4. Produit laminé revêtu selon la revendication 1, **caractérisé en ce que** la rugosité de la surface Ra du produit laminé est de 0,001 µm à 0,03 µm et de préférence de 0,003 à 0,03 µm.

5. Produit laminé revêtu selon la revendication 1, **caractérisé en ce que**, sur les surfaces non anodisées des produits laminés, est appliqué un système de couches pour la réflexion diffuse ou dirigée d'un rayonnement ayant des longueurs d'onde dans le domaine de la lumière visible, en particulier ayant des longueurs d'onde comprises entre 400 et 750 nm.

6. Produit laminé revêtu selon la revendication 5, **caractérisé en ce que** la réflexion est une réflexion dirigée, une réflexion diffuse ou une combinaison de celles-ci.
